# EUROPEAN PATENT APPLICATION

(11) **EP 4 113 588 A1**
(43) Date of publication of application: **04.01.2023**
(21) Application number: 21908944.8
(22) Date of filing: 16.11.2021
(51) Int. Cl.: H01L 21/768

(54) **GAN DEVICE INTERCONNECT STRUCTURE AND PREPARATION METHOD THEREFOR**

(30) Priority: 23.12.2020 CN 202011537165
(71) Applicant: CHINA RESOURCES MICROELECTRONICS (CHONGQING) CO., LTD, Sha Ping Ba District Chongqing 401331 (CN)
(72) Inventor: XIAO, Xia, Chongqing 401331 (CN); WANG, Liming, Chongqing 401331 (CN)
(74) Representative: Canzler & Bergmeier Patentanwälte Partnerschaft mbB
(86) International application number: PCT/CN2021/130919
(87) International publication number: WO 2022/134944

(57) **Abstract**

The present invention relates to a GaN device interconnect structure and a preparation method therefor. The preparation method comprises: providing a semiconductor substrate comprising a source region, a drain region, and a gate region, the surface of the semiconductor substrate defining a first direction and a second direction perpendicular to each other; preparing a gate combination structure, the gate combination structure comprising a gate finger and a gate interconnect reserved portion, the connection direction of two adjacent gate fingers being a first direction; preparing a first dielectric layer and a first layer of interconnect metals; and preparing a second dielectric layer and a second layer of interconnect metals. According to the present invention, the electrical property of the gate is led out on the basis of the gate interconnect reserved portion, and a novel interconnect wiring solution is provided by means of a first source metal interconnect line, a first drain metal interconnect line, a gate metal interconnect line, a second source metal interconnect line, and a second drain metal interconnect line, which facilitates effective control of the gate resistance, the current distribution is uniform, the utilization rate of the chip effective area is effectively improved, and it is suitable for mass production product design of gallium nitride low-voltage and high-power density.

## Description

### Field of Technology

The present invention relates to the field of gallium nitride (GaN) power device design, in particular to a GaN device with an interconnected structure and a method for preparing the same.

### Background

In conventional GaN device preparation, the source, drain, and gate (three terminals) of a GaN device need to be electrically led out, for which wiring through interconnecting metals is required. However, it is often difficult to achieve an effective wiring connection, because there are problems such as increased resistance, active area waste and so on. For example, for a conventional GaN high electron mobility transistor (HEMT) device, its three terminals are all on a front side of the corresponding wafer, and cells of the GaN device are single-finger-like structures, in which case the interconnection layout of the three terminals on the same platform has an important impact on the performance of the GaN device. The interconnection is often achieved by cross-connecting the gate and the source, and then placing the resultant pads outside the device's active area. This leads to problems such as increased active area due to the cross-connecting. The increased active area leads to increased gate resistance, uneven current distribution and low effective area utilization rate of the corresponding chip, thus limiting the performance of the GaN device.

Therefore, it is necessary to provide a GaN device with an interconnected structure and a method for preparing the same to solve the above mentioned problems.

### Summary

In view of the above-mentioned shortcomings of the prior art, the present invention aims to provide a GaN device with an interconnected structure and a method for preparing the same for solving the problem in the prior art that effective interconnection wiring between the gate, drain and source are difficult to achieve, and problems of low utilization of effective area of the chip, large gate electrode, and uneven current distribution caused by the existing interconnection schemes.

The present invention provides a method for preparing a GaN device with an interconnected structure, and the method includes:
providing a semiconductor base, wherein each cell of the semiconductor base comprises a gate region, a plurality of source regions, and a plurality of drain regions;
preparing at least one gate assembly for each cell, wherein the gate assembly is located in the gate region, and comprises at least two gate fingers and at least one gate joint connected to two adjacent gate fingers of the at least two gate fingers, wherein the two adjacent gate fingers are connected along a first direction, and the gate fingers also extend in the first direction; wherein for each of the at least two gate fingers, there is a first source region of the plurality of source regions on one side of the gate finger, and a first drain region of the plurality of drain regions on another side of the gate finger, and a vector from the first source region to the first drain region is in a second direction, with the second direction perpendicular to the first direction;
forming a first dielectric layer covering the semiconductor base and the gate assembly;
performing first metalization to form, on the first dielectric layer, first metal wires, which comprises at least one first metal source-interconnecting wire, at least one first metal drain-interconnecting wire, and at least one first metal gate-interconnecting wire, wherein the first metal wires are spaced apart, alternately arranged, and parallel to the second direction, wherein the at least one first metal source-interconnecting wire is electrically connected to the plurality of source regions by means of contact holes through the first dielectric layer, the at least one first metal drain-interconnecting wire is electrically connected to the plurality of drain regions by means of contact holes through the first dielectric layer, and the at least one first metal gate-interconnecting wire is electrically connected to the gate joint by means of contact holes through the first dielectric layer;
forming a second dielectric layer covering the first dielectric layer, the least one first metal source-interconnecting wire, the least one first metal drain-interconnecting wire, and the least one first metal gate-interconnecting wire;
performing second metalization to form, on the second dielectric layer, at least one second metal source-interconnecting wire, at least one second metal drain-interconnecting wire, and at least one second metal gate-interconnecting wire, wherein the at least one second metal source-interconnecting wire and the at least one second metal drain-interconnecting wire are spaced apart from each other, parallel to the first direction, and alternatively arranged, wherein the at least one second metal source-interconnecting wire is electrically connected to the at least one first metal source-interconnecting wire by means of contact holes through the second dielectric layer, the at least one second metal drain-interconnecting wire is electrically connected to the at least one first metal drain-interconnecting wire by means of contact holes through the second dielectric layer, and the at least one second metal gate-interconnecting wire is electrically connected to the at least one first metal gate-interconnecting wire by means of contact holes through the second dielectric layer.

Optionally, between each two of the at least one first metal gate-interconnecting wire, there are at least one first metal source-interconnecting wire and at least one first metal drain-interconnecting wire that are alternately arranged.

Optionally, the method further comprises: preparing metal source contacts and metal drain contacts on the semiconductor base, and the metal source contacts, the metal drain contacts, and the gate assembly are spaced apart from each other.

Optionally, in each cell, the shortest distance between one of the at least one first metal source-interconnecting wire and one of the at least one first drain-interconnecting wire is less than both the shortest distance between one of the at least one first metal source-interconnecting wire and one of the at least one first metal gate-interconnecting wire, and the shortest distance between one of the at least one first metal drain-interconnecting wire and one of the at least one first metal gate-interconnecting wire.

Optionally, the at least one second metal source-interconnecting wire and the at least one second metal drain-interconnecting wire are alternately arranged and evenly spaced apart.

Optionally, the method further comprises: preparing at least one source pad electrically connected to the at least one second metal source-interconnecting wire, at least one drain pad electrically connected to the at least one second metal drain-interconnecting wire, at least one gate pad electrically connected to the at least one second metal gate-interconnecting wire, and a substrate-lead-out pad.

The present invention also provides a GaN device with an interconnected structure, and the GaN device with an interconnected structure is preferably prepared using the method for preparing a GaN device with an interconnected structure as mentioned above, although other methods may also be used; the GaN device with an interconnected structure includes:
a semiconductor base, wherein each cell of the semiconductor base comprises a gate region, a plurality of source regions, and a plurality of drain regions;
at least one gate assembly for each cell, wherein the gate assembly is located in the gate region, and comprises at least two gate fingers and at least one gate joint connected to two adjacent gate fingers of the at least two gate fingers, wherein the two adjacent gate fingers are connected along a first direction, and the gate figners also extend in the first direction, wherein for each of the at least two gate fingers, there is a first source region of the plurality of source regions on one side of the gate finger, and a first drain region of the plurality of drain regions on another side of the gate finger, wherein a vector from the first source region to the first drain region is in a second direction, with the second direction perpendicular to the first direction;
a first dielectric layer, covering the semiconductor base and the gate assembly;
first metal wires on the first dielectric layer, wherein the first metal wires comprise at least one first metal source-interconnecting wire, at least one first metal drain-interconnecting wire, and at least one first metal gate-interconnecting wire, wherein the first metal wires are spaced apart, alternately arranged, and parallel to the second direction, wherein the at least one first metal source-interconnecting wire is electrically connected to the plurality of source regions by means of contact holes through the first dielectric layer, the at least one first metal drain-interconnecting wire is electrically connected to the plurality of drain regions by means of contact holes through the first dielectric layer, and the at least one first metal gate-interconnecting wire is electrically connected to the gate joint by means of contact holes through the first dielectric layer;
a second dielectric layer, covering the first dielectric layer, the least one first metal source-interconnecting wire, the least one first metal drain-interconnecting wire, and the least one first metal gate-interconnecting wire; and
at least one second metal source-interconnecting wire, at least one second metal drain-interconnecting wire, and at least one second metal gate-interconnecting wire on the second dielectric layer, wherein the at least one second metal source-interconnecting wire and the at least one second metal drain-interconnecting wire are spaced apart from each other, parallel to the first direction, and alternatively arranged, wherein the at least one second metal source-interconnecting wire is electrically connected to the at least one first metal source-interconnecting wire by means of contact holes through the second dielectric layer, the at least one second metal drain-interconnecting wire is electrically connected to the at least one first metal drain-interconnecting wire by means of contact holes through the second dielectric layer, and the at least one second metal gate-interconnecting wire is electrically connected to the at least one first metal gate-interconnecting wire by means of contact holes through the second dielectric layer.

Optionally, contact holes through the first dielectric layer comprise: first source-interconnecting contact holes, first drain-interconnecting contact holes, and first gate-interconnecting contact holes, wherein the first source-interconnecting contact holes are located above the plurality of source regions, the first drain-interconnecting contact holes are located above the plurality of drain regions, the first gate-interconnecting contact holes are located above the gate joint, and projections of the first source-interconnecting contact holes to a line in the first direction do not overlap with those of the first drain-interconnecting contact holes; contact holes through the second dielectric layer comprise: second source-interconnecting contact holes, second drain-interconnecting contact holes, and second gate-interconnecting contact holes, wherein the second source-interconnecting contact holes partially expose the at least one first metal source-interconnecting wire, the second drain-interconnecting contact holes partially expose the at least one first metal drain-interconnecting wire, and the second gate-interconnecting contact holes partially expose the at least one first gate-interconnecting wire.

Optionally, between each two of the at least one first metal gate-interconnecting wire, there are at least one first metal source-interconnecting wire and at least one first metal drain-interconnecting wire that are alternately arranged.

Optionally, a line width of the at least one first metal source-interconnecting wire is the same as that of the at least one first metal drain-interconnecting wire and greater than that of the at least one first metal gate-interconnecting wire; and the line width of the at least one second metal source-interconnecting wire is the same as that of the at least one second metal drain-interconnecting wire.

As mentioned above, in the present invention, the gate joint electrically leads out the gate fingers; the GaN device with an interconnected structure adopts the first metal source-interconnecting wires, first metal drain-interconnecting wires, metal gate-interconnecting wires, second metal source-interconnecting wires, and second metal drain-interconnecting wires to constitute a novel interconnection wiring scheme, facilitating effective control of gate resistance and uniform current distribution; as a result, an effective area utilization rate of the corresponding chip is improved. This invention is suitable for mass production of GaN devices that require low voltage, and high power intensity.

### Brief Description of Drawings

Fig. 1 shows a flowchart illustrating a method for preparing a GaN device with an interconnected structure according to one embodiment of the present invention.
Fig. 2 shows a schematic diagram of a semiconductor base provided in the preparation of a GaN device with an interconnected structure.
Fig. 3 shows a schematic top view of a cell of a GaN device with an interconnected structure, showing source, drain and gate regions of the cell according to one embodiment of the present invention.
Fig. 4 shows a partially enlarged view of source, drain, and gate regions, implementable by the structure shown in Fig. 3.
Fig. 5 shows a schematic diagram of an intermediate structure of a cell of a GaN device with an interconnected structure, after a gate assembly, metal source contacts and metal drain contacts are formed, according to one embodiment of the present invention.
Fig. 6 shows a schematic diagram of an intermediate structure of a cell of a GaN device with an interconnected structure, after first gate-interconnecting contact holes, first source-interconnecting contact holes, and first drain-interconnecting contact holes are formed, according to one embodiment of the present invention.
Fig. 7 shows a partial schematic diagram of an intermediate structure of a GaN device with an interconnected structure, after first gate-interconnecting wires, first source-interconnecting wires, and first drain-interconnecting wires are formed, according to one embodiment of the present invention.
Fig. 8 shows a partial schematic diagram of an intermediate structure of a GaN device with an interconnected structure, after second source-interconnecting contact holes, and second drain-interconnecting contact holes are formed, according to one embodiment of the present invention.
Fig. 9 shows a partial schematic diagram of an intermediate structure of a GaN device with an interconnected structure, after second source-interconnecting wires, and second drain-interconnecting wires are formed, according to one embodiment of the present invention.
Fig. 10 shows a schematic diagram of a structural layout of a GaN device with an interconnected structure, showing a gate pad, source pads, drain pads, and a substrate-lead-out pad.
Fig. 11 shows a wiring scheme according to a comparative embodiment of the present disclosure, where gates and sources are cross-connected and corresponding pads are placed outside the active region.

### Reference Numerals

- 100: Semiconductor base
- 201: Semiconductor substrate
- 202: GaN channel layer
- 203: Barrier layer
- 204: Gate dielectric layer
- 101: Gate region
- 102: Source region
- 103: Drain region
- 104: Gate assembly
- 105: Gate Finger
- 106: Gate joint
- 107: Metal source contact
- 108: Metal drain contact
- 109: Gate-interconnecting contact hole
- 110: First source-interconnecting contact hole
- 111: First drain-interconnecting contact hole
- 112: First metal gate-interconnecting wire
- 113: First metal source-interconnecting wire
- 114: First metal drain-interconnecting wire
- 115: Spacer
- 116: Source-lead-out region
- 117: Drain-lead-out region
- 118: Second source-interconnecting contact hole
- 119: Second drain-interconnecting contact hole
- 120: Second metal source-interconnecting wire
- 121: Second metal drain-interconnecting wire
- 122: Source Pad
- 123: Drain Pad
- 124: Gate Pad
- 125: Substrate-lead-out pad
- S1~S6: Various steps

### Detailed Description

The following describes the implementation of the present disclosure through specific examples, and those skilled in the art can easily understand other advantages and effects of the present disclosure from the content disclosed in this specification. The present disclosure can also be implemented or applied through other different specific embodiments. Various details in this specification can also be modified or changed based on different viewpoints and applications without departing from the spirit of the present disclosure.

For example, when the embodiments of the present disclosure are described in detail, for ease of description, the cross-sectional view showing the device structure will not be partially enlarged according to the general scale, and the schematic diagram is only an example, which should not limit the scope of protection. In addition, the three-dimensional dimensions of length, width and depth should be included in the actual production.

For the convenience of description, spatial relation terms such as "below", "under", "beneath", "on", "above", "up", etc. may be used herein to describe the relationships between an element or feature and other elements or features. It will be understood that these spatial relationship terms are intended to encompass directions/orientations of the device in use or operation other than those depicted in the drawings. In addition, when a first layer is referred to as being "between" a second layer and a third layer, the first layer may be the only layer between the second and third layers, or there may more layers between the two layers. Herein, "between ......" are used to include both endpoints.

In the context of this disclosure, the structure described with a first feature "on top" of a second feature may include embodiments where the first and second features are formed in direct contact, or it may include embodiments where additional features are formed between the first and second features such that the first and second features are not in direct contact.

It should be noted that the drawings provided in this disclosure only illustrate the basic concept of the present invention in a schematic way, so the drawings only show the components related to the present invention. The drawings are not necessarily drawn according to the number, shape and size of the components in actual implementation; during the actual implementation, the type, quantity and proportion of each component can be changed as needed, and the components' layout may also be more complicated.

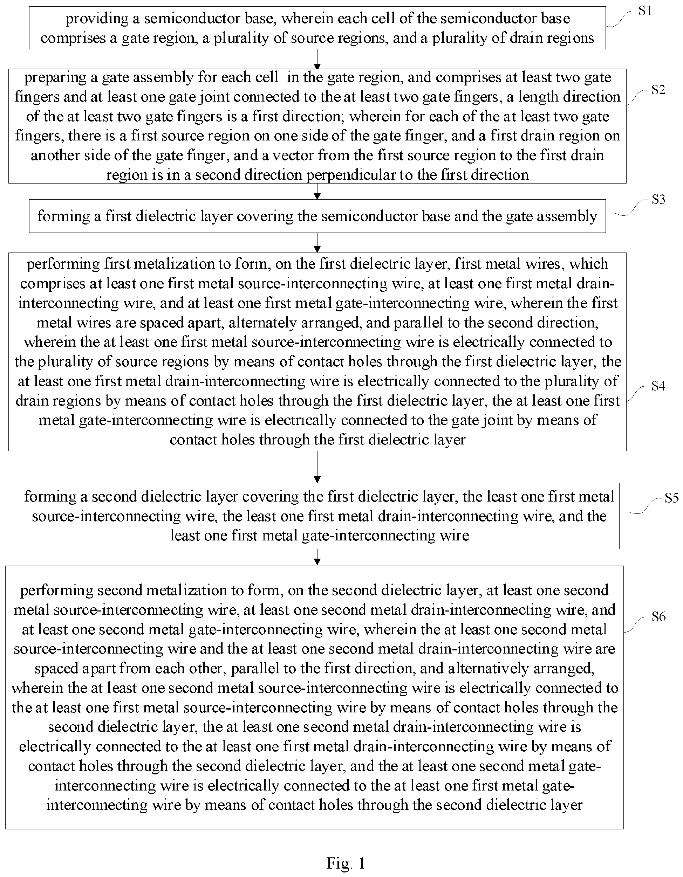

As shown in Fig. 1, the present invention provides a method for preparing of a GaN device with an interconnected structure, and the method includes steps S1-S8. The method for preparing the GaN device with an interconnected structure of the present invention will be described in detail below in conjunction with the accompanying drawings. The method for preparing of a GaN device with an interconnected structure provided by the present invention is not limited by the order shown in Fig. 1, and can be adjusted according to the common knowledge in the field, and Fig. 1 only provides an example of the method for preparing of a GaN device with an interconnected structure.

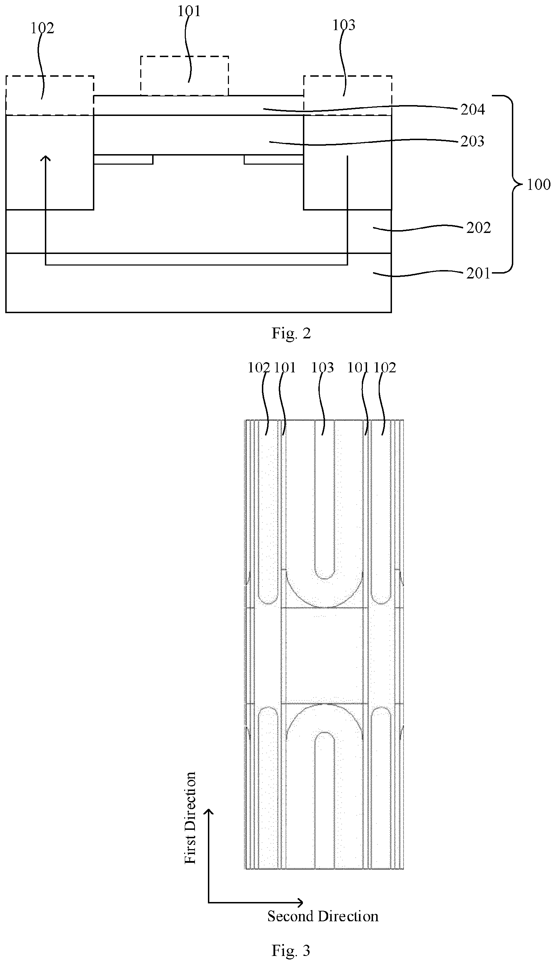

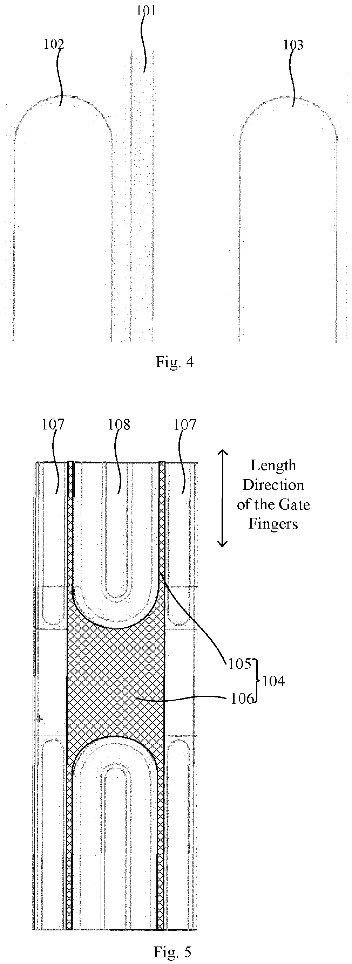

First, as shown in S1 in Fig.1, and Figs. 2-4, a semiconductor base 100 is provided, and each cell of the semiconductor base 100 comprises a gate region 101, a plurality of source regions 102, and a plurality of drain regions 103. In an example, the semiconductor base 100 includes an active region and a non-active region, with the active region including the source regions 102, the drain regions 103, and the gate region 101. The semiconductor base 100 may be any semiconductor structure on which the source, drain, and gate of a device and its interconnection wiring layers need to be formed, and the semiconductor base 100 may be a layered structure. In one example, as shown in Fig. 2, the semiconductor base 100 includes, from the bottom up, a semiconductor substrate 201, a GaN channel layer 202, a barrier layer 203, and a gate dielectric layer 204, wherein a two-dimensional electron gas (2DEG) is formed in the GaN channel layer 202 due to the barrier layer 203, and a source ohmic contact and a drain ohmic contact may also be formed in the semiconductor base corresponding to a source contact and a drain contact to obtain a GaN device in combination with subsequent processes. Fig. 4 shows a partial enlarged view of a cell of the GaN device.

Fig. 3 shows an exemplary layout of the source regions 102, drain regions 103 and gate region 101 in a cell according to one embodiment of the present disclosure. The source regions 102 are used to prepare source contact electrodes for electrical lead-out of the sources of the device, the drain regions 103 are used to prepare drain contact electrodes for electrical lead-out of the drains of the device, and the gate region 101 is used to prepare gate contact electrodes of the device for electrical lead-out of the gates of the device. It is also noted that the source regions 102, for example, represents the area for preparing all source contact electrodes of the device, and the source regions 102 may include a number of source region units in which source contact electrodes are prepared to form a plurality of source contact electrodes, wherein the shape and arrangement of the source contact electrodes, etc., may be changed according to actual needs. Similarly, the drain regions 103 and the gate region 101 can be similarly designed as described above. Hereinafter, the length direction of the gate region 101 as shown in the figures is defined as a first direction, and the direction perpendicular to the first direction is defined as a second direction. In addition, it should also be noted that Fig. 2 does not necessarily correspond to the structure shown in the other figures. The dashed boxes in Fig. 2 show a viable arrangement of a source region 102, a drain region 103, and a gate region 101, relative to the semiconductor base. In some embodiment, they can also be seen as a schematic representation of metal contacts corresponding to the above-mentioned regions.

As shown in S2 of Fig. 1, and Fig. 5, at least one gate assembly 104 is formed for each cell, wherein the gate assembly 104 is located in the gate region 101, and comprises at least two gate fingers 105 and at least one gate joint 106 connected to two adjacent gate fingers of the at least two gate fingers 105, wherein the two adjacent gate fingers 105 may be connected along the first direction, and the gate fingers also extend in the first direction, wherein for each of the at least two gate fingers 105, there is a first source region of the plurality of source regions 102 on one side of the gate finger, and a first drain region of the plurality of drain regions 103 on another side of the gate finger, wherein a vector from the first source region to the first drain region is in the second direction, with the second direction perpendicular to the first direction.

In one embodiment, the gate fingers 105 (as gate of the device) are prepared on the semiconductor base 100 along with the gate joint 106 to facilitate subsequent electrical lead-out of the gates of the device by rewiring. In one embodiment, the gate joint 105 is shared by two adjacent gate fingers 105 that are arranged along the second direction (left and right), or along the first direction. In another embodiment, the gate joint 105 is shared by four gate fingers 105 that are positioned at four vertices of a rectangle. In one embodiment, the gate assembly 104 includes at least two gate joints 106, wherein each gate joint 106 is shared by four gate fingers that are positioned at four vertices of a rectangle. The introduction of the gate joint(s) 106 facilitates lead-out of the gate fingers and helps to reduce the area of the active area, which helps to alleviate wiring difficulties due to the size of the gate fingers. In addition, it also helps to improve the uniformity of current distribution and reduce gate resistance introduced by the gate fingers, and is suitable for mass production of GaN devices that require low voltage, and high power density. In the cell level of a GaN device, the size of the gate fingers is too small for direct interconnection, and therefore, to reduce the gate resistance, the gate joint is introduced and disposed at a central region surrounded by the gate fingers.

As shown in Fig. 5, a number of metal source contacts 107 are then prepared on the semiconductor base 100 corresponding to the source regions 102, and a number of metal drain contacts 108 are prepared on the semiconductor base 100 corresponding to the drain regions 103, with the metal source contacts 107, the metal drain contacts 108, and the gate assembly 104 spaced apart from each other. The metal source contacts 107, the metal drain contacts 108 and the gate assembly 104 can be prepared using conventional processes in the field, the preparation order can be changed according to actual needs, and their materials can be those of conventional metal contacts.

As an example, the metal source contacts 107 include a contact portion formed on the surface of the semiconductor base 100 and a source-field-plate portion connected to the contact portion and extending above the gate fingers 105, with a space between the source-field-plate portion and the top of the gate fingers 105. The source-field-plate portion is prepared simultaneously in this step. The source-field-plate portion can be prepared using existing processes. For example, the above structure is obtained by depositing a dielectric layer and filling it to form a metal layer.

As an example, during actual production, cells, each of which includes metal source contacts 107, metal drain contacts 108 and gate fingers 105, may be arranged in a two-dimensional periodic array, for example, forming a structure comprising a number of rows arranged along the first direction and a number of columns arranged along the second direction; each row extends along the second direction and includes either several metal source contacts 107 from several cells, or several metal drain contacts 108 from several cells, or several gate fingers 105 (or gate joints 106) from several cells, in order to achieve a structure with common source connections and common drain connections; each column of the two-dimensional periodic array may include metal source contacts 107, gate fingers 105, metal drain contacts 108, gate fingers 105, metal source contacts 107, gate fingers 105, and so on, which may constitute different cells. In an example, in each column of the array, components with the same distance to a line in the first direction are components of the same group (for example, metal source contacts), i.e., gate fingers in each column correspond to each other, metal source contacts in each column correspond to each other, and metal drain contacts in each column correspond to each other. Also, as an example, when there are multiple rows, there exist a first row including gate fingers 105, and a second row including gate fingers 105 and adjacent to the first row, two adjacent gate fingers 105 in the first row have two corresponding adjacent gate fingers 105 in the second row, and the four gate fingers 105 are connected to the same gate joint 106.

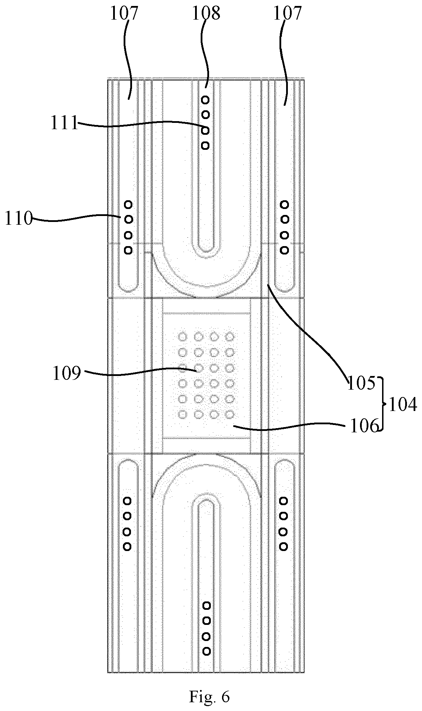

Next, a first layer of contact holes for electrodes of the device is prepared in a first dielectric layer as shown in Fig. 6; specifically, taking one cell as an example, first, the first dielectric layer covering the metal source contacts 107, the metal drain contacts 108, and the gate assembly 104 of the cell is prepared over the semiconductor base 100, wherein the first dielectric layer is not explicitly shown in Fig. 6 in order to show the relationship between the contact holes and the metal contacts. The first dielectric layer may be prepared using existing deposition processes, and is made of, for example, silicon oxide.

The first layer of contact holes include first source-interconnecting contact holes 110, first drain-interconnecting contact holes 111, and first gate-interconnecting contact holes 109, which are prepared in the first dielectric layer; the first source-interconnecting contact holes 110 expose the metal source contacts 107, the first drain-interconnecting contact holes 111 expose the metal drain contacts 108, and the gate-interconnecting contact holes 109 expose the gate joint 106; The first source-interconnecting contact holes 110, and the first drain-interconnecting contact holes 111 are arranged alternately in the first direction; it should be noted that the metal source contacts 107and the metal drain contacts 108 of each cell are not arranged on one straight line; and "the first source-interconnecting contact holes 110, and the first drain-interconnecting contact holes 111 are arranged alternately in the first direction" means projections of the first source-interconnecting contact holes 110 to a line in the first direction do not overlap with those of the first drain-interconnecting contact holes 111. In Fig. 6, all material layers are transparent in order to clearly illustrate positional relationships between the components in different layers. In one example, the contact holes in the first dielectric layer may be prepared dry etching, and may be prepared by any other existing process, such as photolithography-etching.

As an example, in a cell, a first plurality of first source-interconnecting contact holes 110 are provided above a first metal source contact of the metal source contacts 107, and are spaced apart along the first direction; a second plurality of first source-interconnecting contact holes 110 are provided above a second metal source contact of the metal source contacts 107; the first metal source contact and the second metal source contact are symmetric respect to an axis along the first direction; the first plurality of first source-interconnecting contact holes 110 and the second plurality of first source-interconnecting contact holes 110 are also symmetric with respect to the axis, as shown in Fig. 6. Similarly, a first plurality of first drain-interconnecting contact holes 111 are provided above a first metal drain contact of the metal drain contacts 108, and are spaced apart along the first direction; a second plurality of first drain-interconnecting contact holes 111 are provided above a second metal drain contact of the metal drain contacts 108; the first drain contact and the second drain contact are symmetric respect to an axis along the first direction; the first plurality of first drain-interconnecting contact holes 111 and the second plurality of first drain-interconnecting contact holes 111 are also symmetric with respect to the axis.

In an example, the first source-interconnecting contact holes 110 and the first drain-interconnecting contact holes 111 are spaced apart along the length direction of the gate fingers; and in an example, the two are alternately arranged while spaced apart. It means that projections of the first source-interconnecting contact holes 110 to a line in the first direction do not overlap with those of the first drain-interconnecting contact holes 111.

In an example, one of the metal source contacts 107 is provided with a number of the first source-interconnecting contact holes 110 spaced apart in the first direction, and one of the metal drain contacts 108 is provided with a number of the first drain-interconnecting contact holes 111 spaced apart in the first direction. In this case, projections of the first source-interconnecting contact holes 110 and the first drain-interconnecting contact holes 111 in the first direction are alternately arranged and spaced apart. In another example, all the first source-interconnecting contact holes 110 in the same row have coincidental projections to a line in the first direction. Similarly, all the first drain-interconnecting contact holes 111 in the same row have coincidental projections to a line in the first direction.

In an example, the first source-interconnecting contact holes 110 on one of the metal source contacts 107 include a linear array of four holes extending along the first direction, as shown in Fig. 6; the first drain-interconnecting contact holes 111 on one of the metal drain contacts 108 include a linear array of four holes extending along the first direction, as shown in Fig. 6. The gate-interconnecting contact holes 109 may include a two-dimensional array of holes, and the array may be square or rectangular; in one example, as shown in Fig. 6, the array of holes is a 6X4 array.

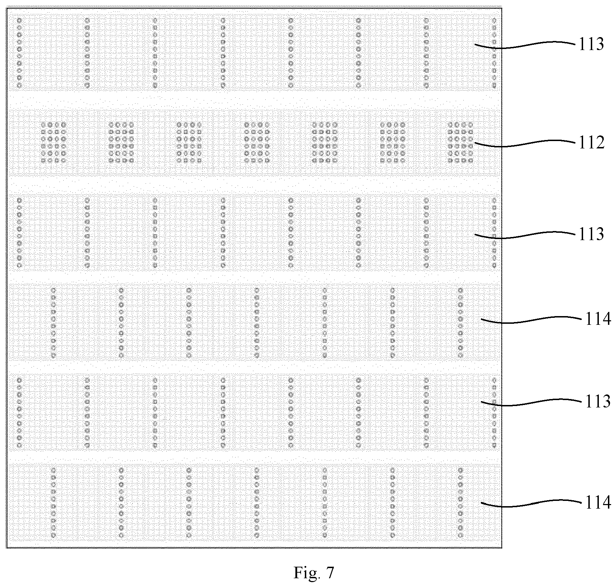

Next, first metalization is performed as shown in S4 of Fig. 1, and Fig. 7, to prepare one or more first metal source-interconnecting wires 113, one or more first metal drain-interconnecting wires 114, and one or more first metal gate-interconnecting wires 112; the first metal source-interconnecting wires 113 fill the first source-interconnecting contact holes 108 and extend to a surface of the first dielectric layer and also extend along the second direction; each of the first metal source-interconnecting wires 113 connects metal source contacts 107 on one row; the first metal drain-interconnecting wires 114 fill the first drain-interconnecting contact holes 109 and extend to the surface of the first dielectric layer and also extend along the second direction; each of the first metal drain-interconnecting wires 114 connects metal drain contacts 108 on one row; the first metal gate-interconnecting wires 112 fill the first gate-interconnecting contact holes 109 and extend to the surface of the first dielectric layer and also extend in the second direction; each of the first metal gate-interconnecting wires 112 connects gate fingers 105 on one row. Fig. 7 shows the first source-interconnecting contact holes 110, the first drain-interconnecting contact holes 111 and the first gate-interconnecting contact holes 109 to show positional relationships between them. Optionally, a line width of the first metal source-interconnecting wires 113 is the same as that of first metal drain-interconnecting wires 114 and greater than that of the first metal gate-interconnecting wires 112.

As can be seen in Fig. 7, top surfaces of the first metal wires (including the first metal source-interconnecting wires 113, the first metal drain-interconnecting wires 114, and the first metal gate-interconnecting wires 112) are strip-shaped. But their cross-sections with cutting planes perpendicular to the semiconductor base consist of T-shaped areas; taking the first metal source-interconnecting wires 113 as an example, their top surfaces are exposed at this stage and are strip-shaped, and their lower portions vertically reach down and fill the corresponding first source-interconnecting contact holes 110. Alternatively, in an example, one metal source contact 107 may correspond to various first metal source-interconnecting wires 113 that are spaced apart, one metal drain contact 108 may correspond to various first metal drain-interconnecting wires 114 that are spaced apart; the first metal source-interconnecting wires 113 and the first metal drain-interconnecting wires 114 are alternately arranged and spaced apart, and the first metal wires interconnect the gate-interconnecting contact holes, the source-interconnecting contact holes, or the drain-interconnecting contact holes along the second direction perpendicular to the length direction of the gate fingers, to achieve same-terminal-interconnection of cells that are side by side in the second direction.

As an example, between each two of the first metal source-interconnecting wires 112, there are at least one first metal source-interconnecting wire 113 and at least one first metal drain-interconnecting wire 114 that are alternately arranged

As an example, in each cell, the shortest distance between one of the first metal source-interconnecting wires 113 and one of the first drain-interconnecting wires 114 is less than both the shortest distance between one of the first metal source-interconnecting wires 113 and one of the first metal gate-interconnecting wires 112, and the shortest distance between one of the first metal drain-interconnecting wires 114 and one of the first metal gate-interconnecting wires 112.

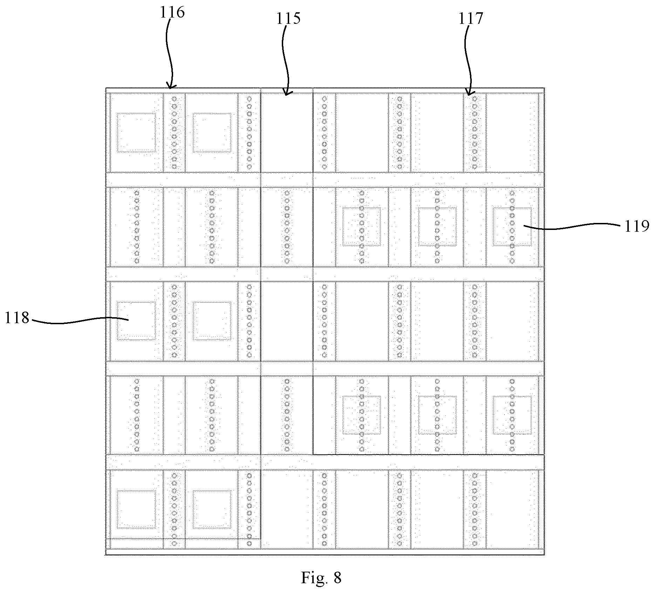

Next, as shown in S5 of Fig. 1 and Fig. 8, a second dielectric layer covering the first metal source-interconnecting wires 113, the first metal drain-interconnecting wires 114, and the first metal gate-interconnecting wires 112 is prepared over the semiconductor base 100; for the sake of clearly showing the positional relationships between the components, Fig. 8 does not show gate fingers, gate joints, and other gate-related components, and all material layers are transparent.

The second dielectric layer includes source-lead-out regions 116 and drain-lead-out regions 117 alternately arranged along the second direction and spaced apart; optionally, a spacer 115 may also exist between one of the source-lead-out regions 116 and one of the drain-lead-out regions 117. Second source-interconnecting contact holes 118 are prepared in the source-lead-out regions 116, second drain-interconnecting contact holes 119 are prepared in the drain-lead-out regions 117, the second source-interconnecting contact holes 118 partially expose the first metal source-interconnecting wires 113, and the second drain-interconnecting contact holes 119 partially expose the first metal drain-interconnecting wires 114. It should be noted that second gate-interconnecting contact holes are similarly formed in the second dielectric layer, but are not shown in Fig. 8 for the sake of clarity.

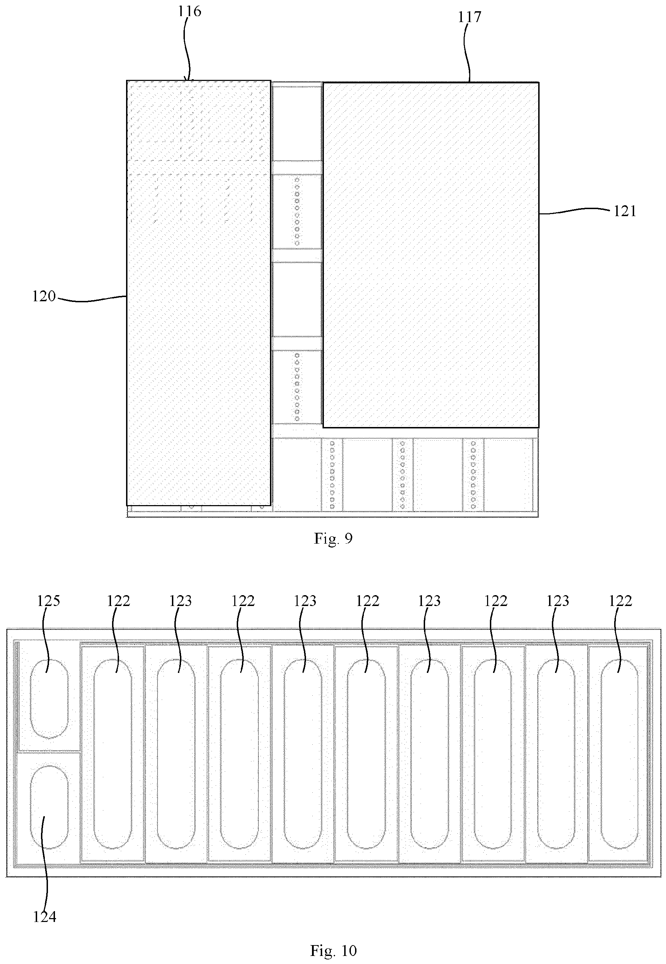

The source-lead-out regions 116 and the drain-lead-out regions 117 are alternately arranged and spaced apart, and they may be of the same or different sizes depending on actual needs. Lead-out positions of the metal source contacts and the metal drain contacts are redistributed in this step by means of the second source-interconnecting contact holes 118 and the second drain-interconnecting contact holes 119 forming spaced-apart lead-out regions alternately arranged along the second direction. In one embodiment, positions of the lead-out regions correspond to those of the pads shown in Fig. 10. In one example, each of the source-lead-out regions 116 partially covers at least two of the first metal source-interconnecting wires 113, and the two first metal source-interconnecting wires are arranged along the first direction; each of the drain-lead-out regions 117 partially covers at least two of the first metal drain-interconnecting wires 114, and the two first metal drain-interconnecting wires are arranged along the first direction; each of the source-lead-out regions 116 covers at least two of the metal source contacts 107 arranged along the second direction, and each of the drain-lead-out regions 117 covers at least two of the metal drain contacts 108 arranged along the second direction. In one example, each of the first metal source-interconnecting wires 113 is partially covered by one of the source-lead-out regions 116, and as mentioned above, the first metal source-interconnecting wires 113 are arranged along the first direction and spaced apart; each of the first metal drain-interconnecting wires 114 is partially covered by one of the drain-lead-out regions 117, and as mentioned above, the first metal drain-interconnecting wires 114 are arranged along the first direction and spaced apart; and as a result, an alternating layout with the source-lead-out regions 116 and the drain-lead-out regions 117 alternately arranged and spaced apart along the second direction in a top view is formed; widths of the lead-out regions along the second direction can be set according to actual needs.

In one example, referring to Fig. 8, the second drain-interconnecting contact holes 119 are provided in positions corresponding to the first drain-interconnecting contact holes 111, i.e., the second drain-interconnecting contact holes 119 partially expose the first metal drain-interconnecting wires above the first drain-interconnecting contact holes 111; viewed from the top, each of the second source-interconnecting contact holes 118 is provided beside a linear array of holes of the first source-interconnecting contact holes 110, and an axis of each second source-interconnecting contact hole 118 parallel to the first direction coincides with an extending direction of the first drain-interconnecting contact holes 111 in the rows adjacent to the row this second source-interconnecting contact hole 118 is in; that is, this second source-interconnecting contact hole 118 is formed in a region between two adjacent linear arrays of the first source-interconnecting contact holes 110 in the second direction, and also between two adjacent linear arrays of the first drain-interconnecting contact holes 111 in the first direction, wherein this second source-interconnecting contact hole 118 partially exposes the part of a corresponding first metal source-interconnecting wire under the region this second source-interconnecting contact hole 118 is in.

As an example, each of the second source-interconnecting contact holes 118 comprises a square array of subunits (not explicitly shown in the figures and are represented by square boxes), and each of the second drain-interconnecting contact holes 119 also comprises a square array of subunits (not explicitly shown in the figures and are represented by square boxes).

Next, as shown in S6 of Fig. 1, and in Fig. 9, second metalization is performed to prepare second metal source-interconnecting wires 120 and second metal drain-interconnecting wires 121, which are parallel to the first direction, alternately arranged and spaced apart with each other. It should be noted that second metal gate-interconnecting wires are similarly prepared, but are not shown in Fig. 9 for the sake of clarity. In an example, the second metal source-interconnecting wires 120 and the second metal drain-interconnecting wires 121 are alternately arranged and evenly spaced apart. In one example, the second metal source-interconnecting wires 120 have the same line width as the second metal drain-interconnecting wires 121.

In one example, the second metal source-interconnecting wires 120 fill the second source-interconnecting contact holes 118 and extend to a surface of the second dielectric layer to cover the source-lead-out regions 116, and the second metal drain-interconnecting wires 121 fill the second drain-interconnecting contact holes 119 and extend to the surface of the second dielectric layer to cover the drain-lead-out regions 117. The second contact holes, including the second drain-interconnecting contact holes, the second source-interconnecting contact holes, and the second gate-interconnecting contact holes, are distributed in accordance with the pads shown in Fig. 10 , while sources and drains corresponding to the first metal wires are arranged along the length direction of the gate fingers, respectively. In this step, second metal wires are formed, including the second metal source-interconnecting wires, the second metal drain-interconnecting wires, and the second metal gate-interconnecting wires, on the basis of which the metal source contacts and the metal drain contacts can be electrically led out; similar to the first metal wires, the second metal wires' cross-sections with cutting planes perpendicular to the semiconductor base consist of T-shaped areas, top surfaces of the second metal wires are strip-shaped, and their lower portions reach down and fill corresponding second contact holes. Taking the second metal source-interconnecting wires 120 as an example, they electrically connect the second source-interconnecting contact holes 118 in the source-lead-out regions 116. In one example, electrical lead-out of metal source contacts in one or more rows arranged along the first direction may be achieved by the source-lead-out regions 116.

Finally, as shown in Fig. 10, source pads 122 electrically connected to the metal source contacts 107, drain pads 123 electrically connected to the metal drain contacts 108, and at least one gate pad 124 electrically connected to the gate assemblies 104 through the gate joints 106 are prepared to obtain the GaN device with an interconnected structure. In this step, the source pads 122, the drain pads 123, and the gate pad 124 are arranged based on the arrangement of the first metal wires and the second metal wires to achieve interconnection and rewiring of terminals of the device. The source pads 122 and the drain pads 123 can be prepared corresponding to the second metal source-interconnecting wires, and the second metal drain-interconnecting wires, respectively, and the gate pad 124 can also be prepared corresponding to the second metal gate-interconnecting wires, although the latter is not shown in the figures. The pads can be prepared using existing processes. Alternatively, the device may also include at least one substrate-lead-out pad 125 electrically connected to the semiconductor substrate to apply electrical signals to the GaN device through the respective pads.

As an example, the gate pad 124 and the substrate-lead-out pad 125 are provided adjacent to each other, and are both beside the source pads 122 and the drain pads 123 that are alternately arranged, as shown in Fig. 10; the gate pad 124 is electrically led out through the second metal gate-interconnecting wires, the source pads 122 are electrically led out through the second metal source-interconnecting wires 120, and the drain pads 123 are electrically led out through the second metal drain-interconnecting wires 121.

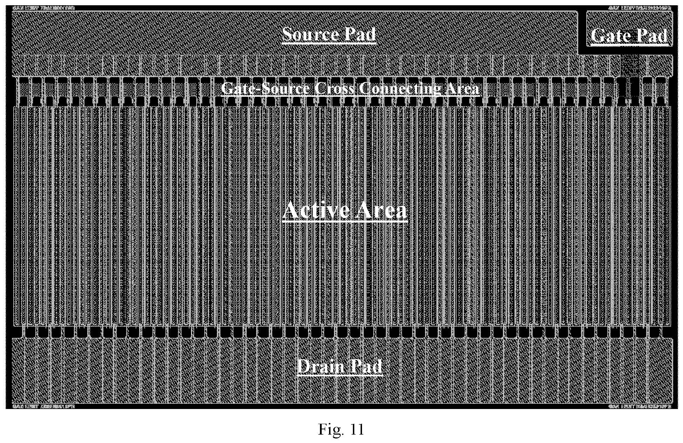

In summary, gate fingers and gate joints are arranged in active areas of the device; metal source/drain-interconnecting contact holes are alternately arranged along a direction perpendicular to the gate fingers; metal source/drain-interconnecting contacts are alternately arranged along the direction perpendicular to the gate fingers; source/drain pads are alternately arranged, sources and the substrate are directly connected through metal wires. A novel interconnection wiring scheme is obtained, and the device designed with this scheme shows great advantages such as reduced gate resistance, improved output performance, and increased active area ratio. Table 1 shows a comparison between a device according to one embodiment of the present disclosure and a traditional multi-finger structure, where the wiring scheme of the traditional structure can be seen in Fig. 11.

**Table 1**

| | Traditional multi-finger structure | Structure of the present disclosure |
|---|---|---|
| Source/drain finger Total length | 557.2 mm | 557.2 mm |
| Single finger Length | 1.4 mm | 0.35 mm |
| Number of fingers | 398 | 398 |
| Source/Drain Finger Width | 1 µm | 1 µm |
| Source/drain metal thickness | 5 µm | 5 µm |
| Drift Zone Width | 3.9 µm | 3.9 µm |
| Pad electrode area | 2.78mm2 | 5.02 mm2 |
| Number of electrodes | 3 | 11 |
| Total area of active area | 5.3 mm | 5.3 mm |
| Total device area | 8.08 mm2 | 6.96 mm2 |
| Proportion of active area | 65% | 76% |

As can be seen, the proportion of active area and pad electrode area are closely related to chip heat dissipation and device power density, and the device designed with the present scheme is significantly improved in terms of chip heat dissipation and device power density.

In addition, as shown in Figs. 9-10, and referring to Figs. 1-8, the present invention also provides a GaN device with an interconnected structure, and the GaN device with an interconnected structure is preferably prepared using the method described above, but other methods can also be used. The GaN device with an interconnected structure comprises:
a semiconductor base 100, wherein each cell of the semiconductor base 100 comprises a gate region 101, a plurality of source regions 102, and a plurality of drain regions 103;
at least one gate assembly 104 formed for each cell, wherein the gate assembly 104 is located in the gate region 101, and comprises at least two gate fingers 105 and at least one gate joint 106 connected to two adjacent gate fingers of the at least two gate fingers 105, wherein the two adjacent gate fingers are connected along a first direction, and the gate fingers also extend in the first direction wherein for each of the at least two gate fingers 105, there is a first source region of the plurality of source regions 102 on one side of the gate finger, and a first drain region of the plurality of drain regions 103 on another side of the gate finger, wherein a vector from the first source region to the first drain region is in the second direction, with the second direction perpendicular to the first direction;
a first dielectric layer, covering the semiconductor base and the gate assembly;
first metal wires on the first dielectric layer, wherein the first metal wires comprise at least one first metal source-interconnecting wire 113, at least one first metal drain-interconnecting wire 114, and at least one first metal gate-interconnecting wire 112, wherein the first metal wires are spaced apart, alternately arranged, and parallel to the second direction, wherein the at least one first metal source-interconnecting wire is electrically connected to the plurality of source regions by means of contact holes through the first dielectric layer, the at least one first metal drain-interconnecting wire is electrically connected to the plurality of drain regions by means of contact holes through the first dielectric layer, the at least one first metal gate-interconnecting wire is electrically connected to the gate joint by means of contact holes through the first dielectric layer;
a second dielectric layer covering the first dielectric layer, the least one first metal source-interconnecting wire, the least one first metal drain-interconnecting wire, and the least one first metal gate-interconnecting wire; and
at least one second metal source-interconnecting wire 120, at least one second metal drain-interconnecting wire 121, and at least one second metal gate-interconnecting wire on the second dielectric layer, wherein the at least one second metal source-interconnecting wire and the at least one second metal drain-interconnecting wire are spaced apart from each other, parallel to the first direction, and alternatively arranged, wherein the at least one second metal source-interconnecting wire is electrically connected to the at least one first metal source-interconnecting wire by means of contact holes through the second dielectric layer, the at least one second metal drain-interconnecting wire is electrically connected to the at least one first metal drain-interconnecting wire by means of contact holes through the second dielectric layer, and the at least one second metal gate-interconnecting wire is electrically connected to the at least one first metal gate-interconnecting wire by means of contact holes through the second dielectric layer.

As an example, the GaN device further comprises source pads 122, drain pads 123, and a gate pad 124, with the source pads electrically connected to the metal source contacts, the drain pads electrically connected to the metal drain contacts, and the gate pad electrically connected to the gate joint.

As an example, contact holes through the first dielectric layer comprise: first source-interconnecting contact holes 110, first drain-interconnecting contact holes 111, and first gate-interconnecting contact holes 109, wherein the first source-interconnecting contact holes are located above the plurality of source regions, the first drain-interconnecting contact holes are located above the plurality of drain regions, the first gate-interconnecting contact holes are located above the gate joint, and projections of the first source-interconnecting contact holes to a line in the first direction do not overlap with those of the first drain-interconnecting contact holes.

As an example, contact holes through the second dielectric layer comprise: second source-interconnecting contact holes 118, second drain-interconnecting contact holes 119, and second gate-interconnecting contact holes, wherein the second source-interconnecting contact holes partially expose the at least one first metal source-interconnecting wire, the second drain-interconnecting contact holes partially expose the at least one first metal drain-interconnecting wire, and the second gate-interconnecting contact holes partially expose the at least one first gate-interconnecting wire.

As an example, between each two of the at least one first metal gate-interconnecting wire 112, there are at least one first metal source-interconnecting wire 113 and at least one first metal drain-interconnecting wire 114 that are alternately arranged.

As an example, a line width of the at least one first metal source-interconnecting wire 113 is the same as that of the at least one first metal drain-interconnecting wire 114 and greater than that of the at least one first metal gate-interconnecting wire 112; and the line width of the at least one second metal source-interconnecting wire 120 is the same as that of the at least one second metal drain-interconnecting wire 121.

In summary, in the present invention, the gate joint electrically leads out the gate fingers; the GaN device with an interconnected structure adopts the first metal source-interconnecting wires, first metal drain-interconnecting wires, metal gate-interconnecting wires, second metal source-interconnecting wires, and second metal drain-interconnecting wires to constitute a novel interconnection wiring scheme, facilitating effective control of gate resistance and uniform current distribution; as a result, an effective area utilization rate of the corresponding chip is improved. This invention is suitable for mass production of GaN devices that require low voltage, and high power intensity. Therefore, the present disclosure effectively overcomes various shortcomings of the prior art and has a high value for industrial application.

The above-mentioned embodiments only exemplarily illustrate the principles and effects of the present disclosure, but are not used to limit the present disclosure. Any person skilled in the art may modify or change the above embodiments without violating the spirit and scope of the present disclosure. Therefore, all equivalent modifications or changes made by those skilled in the art without departing from the spirit and technical concepts disclosed by the present disclosure should still be covered by the attached claims of the present disclosure.

## Claims

1. A method for preparing a GaN device with an interconnected structure, **characterized in that** the method comprises:
providing a semiconductor base, wherein each cell of the semiconductor base comprises a gate region, a plurality of source regions, and a plurality of drain regions;
preparing at least one gate assembly for each cell, wherein the gate assembly is located in the gate region, and comprises at least two gate fingers and at least one gate joint connected to two adjacent gate fingers of the at least two gate fingers, wherein the two adjacent gate fingers are connected along a first direction, and the gate fingers also extend in the first direction; wherein for each of the at least two gate fingers, there is a first source region of the plurality of source regions on one side of the gate finger, and a first drain region of the plurality of drain regions on another side of the gate finger, and a vector from the first source region to the first drain region is in a second direction, with the second direction perpendicular to the first direction;
forming a first dielectric layer covering the semiconductor base and the gate assembly;
performing first metalization to form, on the first dielectric layer, first metal wires, which comprises at least one first metal source-interconnecting wire, at least one first metal drain-interconnecting wire, and at least one first metal gate-interconnecting wire, wherein the first metal wires are spaced apart, alternately arranged, and parallel to the second direction, wherein the at least one first metal source-interconnecting wire is electrically connected to the plurality of source regions by means of contact holes through the first dielectric layer, the at least one first metal drain-interconnecting wire is electrically connected to the plurality of drain regions by means of contact holes through the first dielectric layer, and the at least one first metal gate-interconnecting wire is electrically connected to the gate joint by means of contact holes through the first dielectric layer;
forming a second dielectric layer covering the first dielectric layer, the least one first metal source-interconnecting wire, the least one first metal drain-interconnecting wire, and the least one first metal gate-interconnecting wire;
performing second metalization to form, on the second dielectric layer, at least one second metal source-interconnecting wire, at least one second metal drain-interconnecting wire, and at least one second metal gate-interconnecting wire, wherein the at least one second metal source-interconnecting wire and the at least one second metal drain-interconnecting wire are spaced apart from each other, parallel to the first direction, and alternatively arranged, wherein the at least one second metal source-interconnecting wire is electrically connected to the at least one first metal source-interconnecting wire by means of contact holes through the second dielectric layer, the at least one second metal drain-interconnecting wire is electrically connected to the at least one first metal drain-interconnecting wire by means of contact holes through the second dielectric layer, and the at least one second metal gate-interconnecting wire is electrically connected to the at least one first metal gate-interconnecting wire by means of contact holes through the second dielectric layer.

2. The method for preparing a GaN device with an interconnected structure according to claim 1, wherein between each two of the at least one first metal gate-interconnecting wire, there are at least one first metal source-interconnecting wire and at least one first metal drain-interconnecting wire that are alternately arranged.

3. The method for preparing a GaN device with an interconnected structure according to claim 1, **characterized in that** the method further comprises: preparing metal source contacts and metal drain contacts on the semiconductor base, and the metal source contacts, the metal drain contacts, and the gate assembly are spaced apart from each other.

4. The method for preparing a GaN device with an interconnected structure according to claim 1, **characterized in that**, in each cell, the shortest distance between one of the at least one first metal source-interconnecting wire and one of the at least one first drain-interconnecting wire is less than both the shortest distance between one of the at least one first metal source-interconnecting wire and one of the at least one first metal gate-interconnecting wire, and the shortest distance between one of the at least one first metal drain-interconnecting wire and one of the at least one first metal gate-interconnecting wire.

5. The method for preparing a GaN device with an interconnected structure according to claim 1, **characterized in that** the at least one second metal source-interconnecting wire and the at least one second metal drain-interconnecting wire are alternately arranged and evenly spaced apart.

6. The method for preparing a GaN device with an interconnected structure according to claim 1, **characterized in that** the method further comprises: preparing at least one source pad electrically connected to the at least one second metal source-interconnecting wire, at least one drain pad electrically connected to the at least one second metal drain-interconnecting wire, at least one gate pad electrically connected to the at least one second metal gate-interconnecting wire, and a substrate-lead-out pad.

7. A GaN device with an interconnected structure, **characterized in that** the GaN device with an interconnected structure comprises:
a semiconductor base, wherein each cell of the semiconductor base comprises a gate region, a plurality of source regions, and a plurality of drain regions;
at least one gate assembly for each cell, wherein the gate assembly is located in the gate region, and comprises at least two gate fingers and at least one gate joint connected to two adjacent gate fingers of the at least two gate fingers, wherein the two adjacent gate fingers are connected along a first direction, and the gate fingers also extend in the first direction, wherein for each of the at least two gate fingers, there is a first source region of the plurality of source regions on one side of the gate finger, and a first drain region of the plurality of drain regions on another side of the gate finger, wherein a vector from the first source region to the first drain region is in a second direction, with the second direction perpendicular to the first direction;
a first dielectric layer, covering the semiconductor base and the gate assembly;
first metal wires on the first dielectric layer, wherein the first metal wires comprise at least one first metal source-interconnecting wire, at least one first metal drain-interconnecting wire, and at least one first metal gate-interconnecting wire, wherein the first metal wires are spaced apart, alternately arranged, and parallel to the second direction, wherein the at least one first metal source-interconnecting wire is electrically connected to the plurality of source regions by means of contact holes through the first dielectric layer, the at least one first metal drain-interconnecting wire is electrically connected to the plurality of drain regions by means of contact holes through the first dielectric layer, and the at least one first metal gate-interconnecting wire is electrically connected to the gate joint by means of contact holes through the first dielectric layer;
a second dielectric layer, covering the first dielectric layer, the least one first metal source-interconnecting wire, the least one first metal drain-interconnecting wire, and the least one first metal gate-interconnecting wire;
at least one second metal source-interconnecting wire, at least one second metal drain-interconnecting wire, and at least one second metal gate-interconnecting wire on the second dielectric layer, wherein the at least one second metal source-interconnecting wire and the at least one second metal drain-interconnecting wire are spaced apart from each other, parallel to the first direction, and alternatively arranged, wherein the at least one second metal source-interconnecting wire is electrically connected to the at least one first metal source-interconnecting wire by means of contact holes through the second dielectric layer, the at least one second metal drain-interconnecting wire is electrically connected to the at least one first metal drain-interconnecting wire by means of contact holes through the second dielectric layer, and the at least one second metal gate-interconnecting wire is electrically connected to the at least one first metal gate-interconnecting wire by means of contact holes through the second dielectric layer.

8. The GaN device with an interconnected structure according to claim 7, **characterized in that** contact holes through the first dielectric layer comprise: first source-interconnecting contact holes, first drain-interconnecting contact holes, and first gate-interconnecting contact holes, wherein the first source-interconnecting contact holes are located above the plurality of source regions, the first drain-interconnecting contact holes are located above the plurality of drain regions, the first gate-interconnecting contact holes are located above the gate joint, and projections of the first source-interconnecting contact holes to a line in the first direction do not overlap with those of the first drain-interconnecting contact holes; further **characterized in that** contact holes through the second dielectric layer comprise: second source-interconnecting contact holes, second drain-interconnecting contact holes, and second gate-interconnecting contact holes, wherein the second source-interconnecting contact holes partially expose the at least one first metal source-interconnecting wire, the second drain-interconnecting contact holes partially expose the at least one first metal drain-interconnecting wire, and the second gate-interconnecting contact holes partially expose the at least one first gate-interconnecting wire.

9. The GaN device with an interconnected structure according to claim 7, **characterized in that** between each two of the at least one first metal gate-interconnecting wire, there are at least one first metal source-interconnecting wire and at least one first metal drain-interconnecting wire that are alternately arranged.

10. The GaN device with an interconnected structure according to any one of claim 7, **characterized in that** a line width of the at least one first metal source-interconnecting wires is the same as that of the at least one first metal drain-interconnecting wire and greater than that of the at least one first metal gate-interconnecting wire; and the line width of the at least one second metal source-interconnecting wire is the same as that of the at least one second metal drain-interconnecting wire.

11. The method for preparing a GaN device with an interconnected structure according to claim 2, **characterized in that** the method further comprises: preparing at least one source pad electrically connected to the at least one second metal source-interconnecting wire, at least one drain pad electrically connected to the at least one second metal drain-interconnecting wire, at least one gate pad electrically connected to the at least one second metal gate-interconnecting wire, and a substrate-lead-out pad.

12. The method for preparing a GaN device with an interconnected structure according to claim 3, **characterized in that** the method further comprises: preparing at least one source pad electrically connected to the at least one second metal source-interconnecting wire, at least one drain pad electrically connected to the at least one second metal drain-interconnecting wire, at least one gate pad electrically connected to the at least one second metal gate-interconnecting wire, and a substrate-lead-out pad.

13. The method for preparing a GaN device with an interconnected structure according to claim 4, **characterized in that** the method further comprises: preparing at least one source pad electrically connected to the at least one second metal source-interconnecting wire, at least one drain pad electrically connected to the at least one second metal drain-interconnecting wire, at least one gate pad electrically connected to the at least one second metal gate-interconnecting wire, and a substrate-lead-out pad.

14. The GaN device with an interconnected structure according to any one of claim 8, **characterized in that** a line width of the at least one first metal source-interconnecting wires is the same as that of the at least one first metal drain-interconnecting wire and greater than that of the at least one first metal gate-interconnecting wire; and the line width of the at least one second metal source-interconnecting wire is the same as that of the at least one second metal drain-interconnecting wire.

15. The GaN device with an interconnected structure according to any one of claim 9, **characterized in that** a line width of the at least one first metal source-interconnecting wires is the same as that of the at least one first metal drain-interconnecting wire and greater than that of the at least one first metal gate-interconnecting wire; and the line width of the at least one second metal source-interconnecting wire is the same as that of the at least one second metal drain-interconnecting wire.
